# EUROPEAN PATENT SPECIFICATION

(11) **EP 1 411 555 B1**
(45) Date of publication and mention of the grant of the patent: **22.11.2006**
(21) Application number: 03252364.9
(22) Date of filing: 14.04.2003
(51) Int. Cl.: H01L 29/792, H01L 29/788, H01L 29/51

(54) **Nonvolatile silicon/oxide/nitride/silicon/nitride/oxide/silicon memory**
Nichtflüchtige Silizium/Oxid/Nitrid/Silizium/Nitrid/Oxid/Silizium Speicheranordnung
Mémoire non-volatile de type silicium/oxyde/nitrure/silicium/nitrure/oxyde/silicium

(30) Priority: 14.10.2002 KR 2002062482
(43) Date of publication of application: 21.04.2004
(73) Proprietor: SAMSUNG ELECTRONICS CO., LTD., Suwon-City, Kyungki-do (KR)
(72) Inventor: Chae, Soo-doo, Seoul (KR); Kim, Ju-Hyung, Mohyeon-myeon, Yongin-city, Kyungki-do (KR); Kim, Chung-woo, Bundang-gu, Seongnam-city, Kyungki-do (KR); Chae, Hee-soon, Cheongju-city, Chungcheongbuk-do (KR); Ryu, Won-il, Seoul (KR)
(74) Representative: Greene, Simon Kenneth

(56) References cited:
- WO-A-01/37347
- US-A- 5 319 230
- US-A- 5 937 295
- US-A1- 2002 014 655
- LIU Z ET AL: "METAL NANOCRYSTAL MEMORIES-PART II: ELECTRICAL CHARACTERISTICS" IEEE TRANSACTIONS ON ELECTRON DEVICES, IEEE INC. NEW YORK, US, vol. 49, no. 9, September 2002 (2002-09), pages 1614-1622, XP001116668 ISSN: 0018-9383
- PATENT ABSTRACTS OF JAPAN vol. 0050, no. 13 (P-046), 27 January 1981 (1981-01-27) & JP 55 142488 A (NEC CORP), 7 November 1980 (1980-11-07)
- CHAN T Y ET AL: "A TRUE SINGLE-TRANSISTOR OXIDE-NITRIDE-OXIDE EEPROM DEVICE" IEEE ELECTRON DEVICE LETTERS, IEEE INC. NEW YORK, US, vol. EDC-8, no. 3, 3 March 1987 (1987-03-03), pages 93-95, XP002047234 ISSN: 0741-3106

## Description

The present invention relates to nonvolatile memory, and more particularly, to silicon/oxide/nitride/silicon/nitride/oxide/silicon (SONSNOS) memory having an improved capacity.

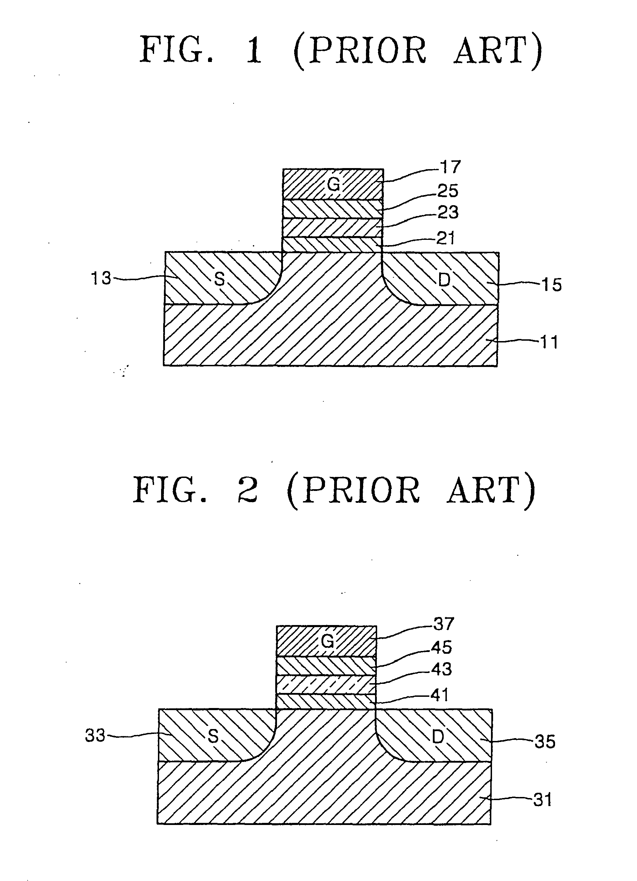

FIG. 1 is a sectional view illustrating conventional flash electrically erasable programmable read only memory (EEPROM). Here, the flash EEPROM, as nonvolatile memory, stores data even in a power off state.

Referring to FIG. 1, a gate electrode 17 is located on a substrate 11 having a source electrode 13 and a drain electrode 15, and a gate oxide 21, a floating gate 23, and an insulating layer 25 are sequentially stacked between the gate electrode 17 and the substrate 11.

In general, a flash memory is programmed using thermions that are injected from a portion of the substrate 11, in particular, the channel of electrons that is formed between the source electrode 13 and the drain electrode 15. A thermion injection mechanism includes converting the electrons that transfer negative charges to the floating gate 23 into thermions. Thereafter, the source electrode 13 and a corresponding portion of the substrate 11 are grounded and a relatively high positive voltage is applied to the gate electrode 17 in order to induce an electric field that attracts the electrons. In addition, a proper positive voltage is applied to the drain electrode 15 to generate thermions. The thermions are injected into the floating gate 23 by the electric field of the gate electrode 17. When a sufficient amount of negative charge is accumulated in the floating gate 23, the negative potential of the floating gate 23 is increased to the threshold voltage of a field effect transistor (FET) to obstruct the electrons from flowing through the channel. The amount of read current is used to determine whether the flash memory is programmed. The discharge of the floating gate is referred to as erasing. Here, erasing is performed by a tunneling mechanism between the floating gate and the substrate. An erasing operation of data from a flash memory is performed by applying a high positive voltage to a source electrode and grounding a gate electrode and a substrate while floating a drain electrode of a memory cell.

However, since a flash memory has disadvantages of a low retention, a silicon/oxide/nitride/oxide/silicon (SONOS) memory device for extending information capacity and improving process performance is introduced by Chan et al., *IEEE Electron Device Letters*, Vol. 8, No. 3, PP 93, 1987.

FIG. 2 is a sectional view illustrating a conventional SONOS memory.

Referring to FIG. 2, a gate electrode 37 is located on a substrate 31 having a source electrode 33 and a drain electrode 35, and silicon oxide layers 41 and 45 as insulating layers are formed between the substrate 31 and the gate electrode 37. In addition, a non-conductive dielectric layer 43 for trapping electrons is interposed between the silicon oxide layers 41 and 45.

When a SONOS memory having two bits per cell is operated, two bits, a right bit and a left bit, of the SONOS memory use a conventional programming method using thermions; however, each bit reads data at a relatively low gate voltage in different directions. For example, a right bit of the SONOS memory is programmed by applying a programming voltage to a gate electrode or a drain electrode while grounding or applying a low voltage to a source electrode. Accordingly, thermions are sufficiently accelerated and injected into a region of a non-conductive dielectric layer near the drain electrode. However, the SONOS memory is read by applying a reading voltage to the gate electrode and the source electrode in an opposite direction while grounding or applying a low voltage to the drain electrode. Accordingly, a left bit is programmed and read by exchanging the voltages of the source electrode and the drain electrode. When one bit is programmed, the information in the other bit is maintained.

The SONOS memory reads data in a reverse direction using a relatively low level of gate voltage so that the drop of the potential that crosses the channel is significantly reduced. Accordingly, the effects of the charges trapped in a local trapping region are increased to enable the programming of the SONOS memory at a high rate. In addition, the SONOS memory can improve the erasing mechanism by applying a proper erasing voltage to the gate electrode and the drain electrode of the right bit and the source electrode of the left bit. Furthermore, the SONOS memory can improve the lifespan of the device by preventing the SONOS memory from being worn down in a cycling operation.

However, regardless of the advantages of the SONOS memory, a memory that has a larger capacity than the conventional SONOS memory and can be programmed at a higher rate than the conventional SONOS memory is required.

WO-A1-01/37347 describes a non-volatile memory. In an embodiment, the structure is substrate, oxide layer, nitride layer, dielectric layer, nitride layer, oxide layer and gate layer.

US-A-2002/0014655 describes the use of nanocrystalline silicon as charge traps in a memory device.

Liu et al, "Metal Nanocrystal Memories - Part II: Electrical characteristics", IEEE transactions on electronic devices vol 49, number 7, 2002, pages 1614 to 1622, describes the use of metal nanocrystals.

A multi level structure of quantum dots is described in US-A-5,937,295.

According to an aspect of the present invention, there is provided a silicon/oxide/nitride/silicon/nitride/oxide/silicon (SONSNOS) memory according to claim 1.

Here, it is preferable that each of the first and second insulating layers is formed of one selected from the group formed of SiO₂, Al₂O₃, TaO₂, and TiO₂.

It is preferable that each of the first and second dielectric layers is formed of one of Si₃N₄ and PZT.

It is preferable that the group IV semiconductor material is one of Si and Ge.

It is preferable that the metal is one of gold (Au) and aluminum (Al).

It is preferable that the nano quantum dots are formed by one of a LPCVD method and a sputtering method.

According to still another aspect of the present invention, there is provided a multi-SONSNOS memory having a semiconductor substrate including source and drain electrodes that are separated by a predetermined distance and a channel for moving electrons between the source and drain electrodes, and a gate electrode formed on the semiconductor substrate to control the input of the electrons from the channel comprising first and second insulating layers stacked on the channel of the substrate; a plurality of dielectric layers formed on the first insulating layer and under the second insulating layer; and a plurality of group IV semiconductor layers interposed between every dielectric layer.

According to yet still another aspect of the present invention, there is provided a multi-SONSNOS memory having a semiconductor substrate including source and drain electrodes that are separated by a predetermined distance and a channel for moving electrons between the source and drain electrodes, and a gate electrode formed on the semiconductor substrate to control the input of the electrons from the channel comprising first and second insulating layers stacked on the channel of the substrate; a plurality of dielectric layers formed on the first insulating layer and under the second insulating layer; and nano quantum dots formed of a group IV semiconductor material and are interposed between every dielectric layer.

Here, it is preferable that each of the first and second insulating layers are formed of one selected from the group formed of SiO₂, Al₂O₃, TaO₂, and TiO₂.

It is preferable that each of the first and second dielectric layers is formed of one of Si₃N₄ and PZT.

It is preferable that the group IV semiconductor material is one of Si and Ge.

It is preferable that the metal is one of Au and Al.

It is preferable that the nano quantum dots are formed by one of a LPCVD method and a sputtering method.

The group IV semiconductor layer or layers, or the layer or layers comprising nano quantum dots,

The present invention provides a memory having a high operation rate and a high capacity using the advantages of silicon/oxide/nitride/oxide/silicon (SONOS) memory.

In each of the arrangements, one or more intermediate layers provides trap sites over and above those in the dielectric layers. The trap sites may be formed at the interface between the intermediate layer or layers and adjacent layers, or in the intermediate layer or layers itself.

The SONSNOS memory according to the present invention increases the trap sites for storing the electrons to improve the programming rate and the capacity of the memory by inserting silicon layers.

The above aspects and advantages of the present invention will become more apparent by describing in detail preferred embodiments thereof with reference to the attached drawings in which:
FIG. 1 is a sectional view illustrating a conventional flash memory;
FIG. 2 is a sectional view illustrating a conventional SONOS memory;
FIG. 3 is a perspective view illustrating silicon/oxide/nitride/silicon/nitride/oxide/silicon (SONSNOS) memory according to a first embodiment of the present invention;
FIG. 4A is a perspective view illustrating SONSNOS memory according to a second embodiment of the present invention;
FIG. 4B is an enlarged view illustrating circle A of FIG. 4A;
FIG. 5 is a sectional view illustrating multi-SONSNOS memory according to a third embodiment of the present invention;
FIG. 6 is a sectional view illustrating multi-SONSNOS memory according to a fourth embodiment of the present invention; and
FIG. 7 is a graph illustrating changes in flat band voltages in multi-SONSNOS memory according to the first embodiment of the present invention and a conventional SONOS memory in response to changes in gate voltages for recording and erasing the memories.

The present invention will now be described more fully with reference to the accompanying drawings, in which preferred embodiments of the invention are shown.

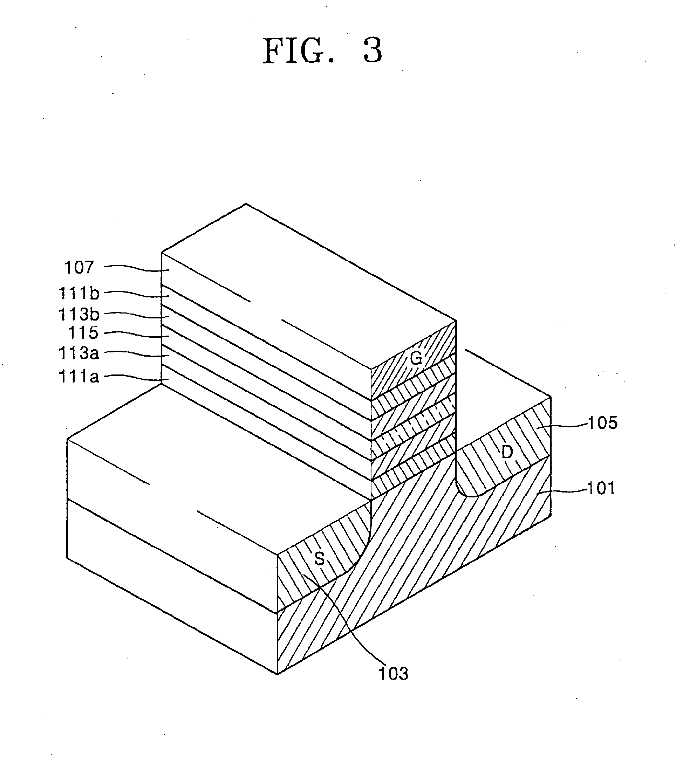

FIG. 3 is a perspective view illustrating silicon/oxide/nitride/silicon/nitride/oxide/silicon (SONSNOS) memory according to a first embodiment of the present invention.

Referring to FIG. 3, a gate electrode 107 is located on a substrate 101 having a source electrode 103 and a drain electrode 105, and a multi-layered ONSNO layer is interposed between the substrate 101 and the gate electrode 107 to trap electrons. An electron channel is formed between the source and drain electrodes 103 and 105. Here, the gate electrode 107 may be formed using a semiconductor, such as silicon (Si), or metal.

The ONSNO layer includes first and second oxide layers 111a and 111b respectively located on the substrate 101 and under the gate electrode 107, first and second nitride layers 113a and 113b respectively located on the first oxide layer 111a and under the second oxide layer 111b, and a silicon layer 115 interposed between the first and second nitride layers 113a and 113b.

The first and second oxide layers 111a and 111b are formed of an insulating material, such as silicon oxide (SiO), aluminum oxide (Al₂O₃), tantalum oxide (TaO₂), or titanium oxide (TiO₂), and the first and second nitride layers 113a and 113b are formed of a material including a trap site, such as silicon nitride (Si₃N₄) or PZT, to an amount of larger than 10¹²/cm². In addition, the silicon layer 115 can be substituted by a germanium layer.

In order to fabricate the SONSNOS memory according to the first embodiment of the present invention, the channel region is formed by lightly implanting ions into the substrate 101 and the ONSNO layer is formed on the channel region. Thereafter, a semiconductor layer for forming the gate electrode 107 is deposited on the ONSNO layer, and the gate electrode 107 is etched by patterning the semiconductor layer using a photography process. Ions are heavily and lightly implanted using the gate electrode 107 as a mask to form the source and drain electrodes 103 and 105 so that the gate electrode 107 is completed.

In order to store information in the SONSNOS memory, a first positive voltage is applied to the drain electrode 105 while grounding the source electrode 103 or applying a low voltage to the source electrode 103, and a second positive voltage higher than the first positive voltage is applied to the gate electrode 107. In this case, an electron channel is formed from the source electrode 103 to the drain electrode 105, and the electrons moving to the drain electrode 105 are trapped in the interface between the first nitride layer 113a and the silicon layer 115, the defect of the silicon layer 115, or the interface between the silicon layer 115 and the second nitride layer 113b by tunneling the first oxide layer 111a due to the electric field, which is formed in the gate electrode 107. Since the SONSNOS memory according to the first embodiment of the present invention increases the site for trapping the electrons compared to the conventional SONOS memory, the SONSNOS memory can secure a larger capacity.

In order to read information from the memory, a third positive voltage that is lower than the first positive voltage is applied to the drain electrode 105, and the voltage of the gate electrode 107 is set as a fourth voltage that is lower than the third voltage. When a current over a reference current flows between the source and drain electrodes 103 and 105, data having a value 1 is assigned, and when a current lower than the reference current flows between the source and drain electrodes 103 and 105, data having a value 0 is assigned, based on the polarity of the threshold voltage of the memory cell in order to read the recorded information.

In order to erase the memory cell, 0 V is applied to the gate electrode 107, a high voltage is applied to the source region 103, and the drain electrode 105 is opened. Accordingly, electrons are withdrawn to the source region 103 so that the information in the memory cell is erased.

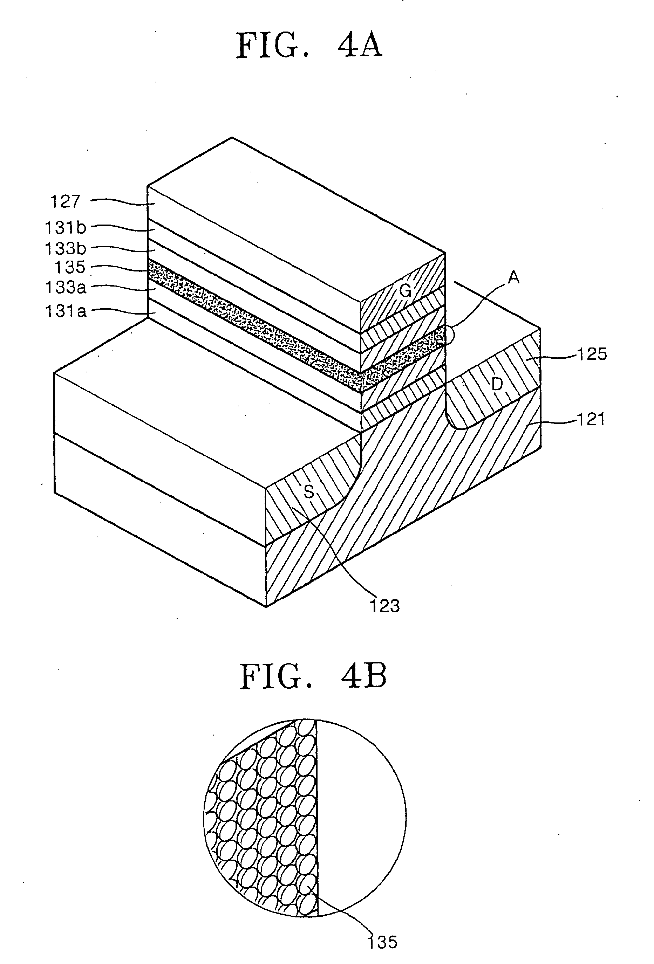

FIG. 4A is a perspective view illustrating an SONSNOS memory according to a second embodiment of the present invention.

Reference numeral 121 denotes a substrate, 123 denotes a source electrode, 125 denotes a drain electrode, 127 denotes a gate electrode, 131a denotes a first oxide layer, 131 b denotes a second oxide layer, 133a denotes a first nitride layer, 133b denotes a second nitride layer, and 135 denotes silicon quantum dots. The structure of the SONSNOS memory according to the second embodiment of the present invention is similar to the structure of the SONSNOS memory according to the first embodiment of the present invention, except for the inclusion of the silicon quantum dots 135 instead of the silicon layer 115. Here, metal quantum dots formed of gold (Au) or aluminum (Al) may be formed instead of the silicon quantum dots 135.

FIG. 4B is an enlarged view illustrating a circle A of FIG. 4A.

The silicon quantum dots 135 can be substituted by metal quantum dots, and the silicon quantum dots 135 or the metal quantum dots can be manufactured by a physical or chemical method.

Examples of the physical method of manufacturing the silicon quantum dots 135 or the metal quantum dots include a sputtering method, a vacuum synthesis method, a gas-phase synthesis method, a condensed phase synthesis method, a high deposition method using an ionized cluster beam, a consolidation method, a high-speed milling method, a mixalloy processing method, a deposition method, and a sol-gel method. An example of the chemical method of manufacturing the silicon quantum dots 135 or the metal quantum dots includes a low pressure chemical vapor deposition (LPCVD) method.

Referring back to FIG. 4A, in order to fabricate the SONSNOS memory according to the second embodiment of the present invention, ions are lightly implanted into the substrate 121 to form a channel region. After the first oxide layer 131 a and the first nitride layer 133a are deposited, the silicon quantum dots 135 are formed on the first nitride layer 133a using a physical or chemical method. Thereafter, the second nitride layer 133b, the second oxide layer 131 b, and a semiconductor layer for forming the gate electrode 127 are deposited on the silicon quantum dots 135, and the layers are patterned and etched as shown in FIG. 4A. Ions are heavily implanted using the semiconductor layer for the gate electrode 127 as a mask. Accordingly, the source and drain electrodes 123 and 125 are formed, and the gate electrode 127 is formed.

The reading, recording, and erasing operations of the SONSNOS memory according to the second embodiment of the present invention are the same as those of the SONSNOS memory according to the first embodiment of the present invention. However, the SONSNOS memory according to the second embodiment of the present invention increases the capacity by enlarging the trap site that stores the electrons through forming the silicon quantum dots 135 or the metal quantum dots.

SONSNOS memories according to a third embodiment and a fourth embodiment of the present invention form multi-layered oxide/nitride/silicon/nitride/oxide/silicon (ONSNOS) layers in the SONSNOS memories according to the first and second embodiments of the present invention in order to increase the capacity.

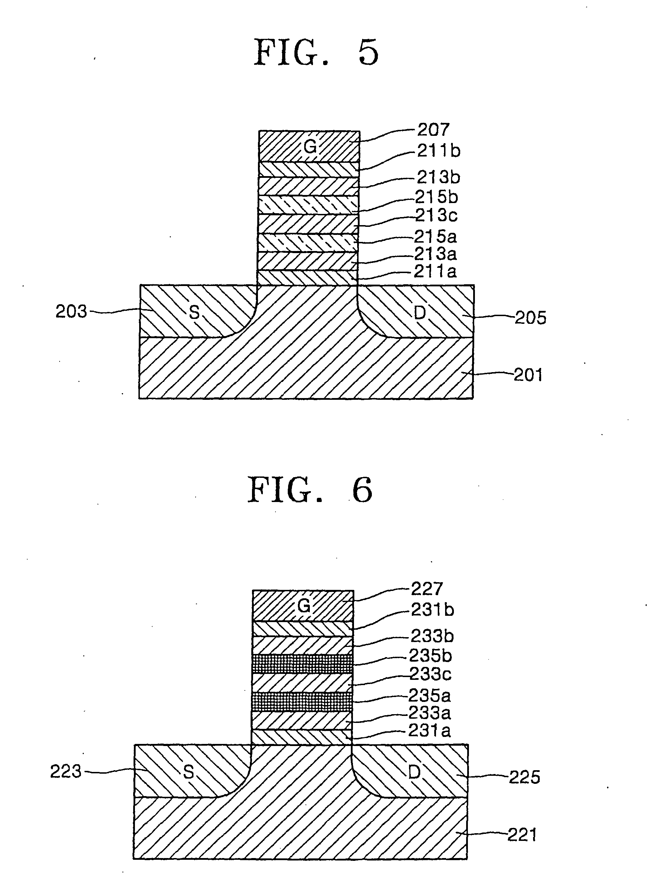

FIG. 5 is a sectional view illustrating a multi-SONSNOS memory according to the third embodiment of the present invention.

Referring to FIG. 5, an oxide/nitride/silicon/nitride/silicon/nitride/oxide (ONSNSNO) layer is interposed between a substrate 201 and a gate electrode 207. A source electrode 203 and a drain electrode 205 are formed in the substrate 201. The ONSNSNO layer includes first and second oxide layers 211a and 211b respectively located on the substrate 201 and under the gate electrode 207, first and second nitride layers 213a and 213b respectively arranged on the first oxide layer 211a and under the second oxide layer 211b, first and second silicon layers 215a and 215b respectively formed on the first nitride layer 213a and under the second nitride layer 213b, and a third nitride layer 213c interposed between the first and second silicon layers 215a and 215b.

FIG. 6 is a sectional view illustrating multi-SONSNOS memory according to the fourth embodiment of the present invention.

Referring to FIG. 6, the multi-SONSNOS memory according to the fourth embodiment of the present invention has a structure similar to that of the multi-SONSNOS memory according to the third embodiment of the present invention, except for the inclusion of the first and second silicon quantum dots 235a and 235b instead of the first and second silicon layers 215a and 215b. Here, first and second metal quantum dots can be formed instead of the first and second silicon quantum dots 235a and 235b. The metal quantum dots can be formed of Au or Al.

The multi-SONSNOS memories according to the third and fourth embodiments of the present invention shown in FIGS. 5 and 6 have multi-layered trap sites storing electrons to increase the capacity in comparison to the SONSNOS memories according to the first and second embodiments of the present invention shown in FIGS. 3 and 4A.

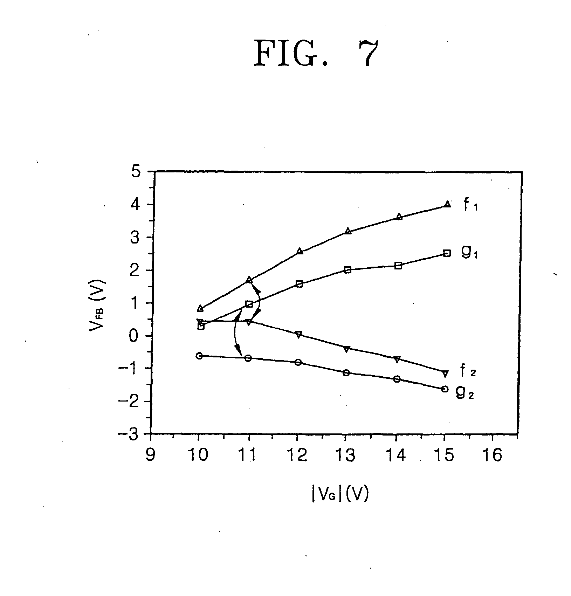

FIG. 7 is a graph illustrating changes in flat band voltages of the conventional SONOS memory and the SONSNOS memory according to the first embodiment of the present invention in response to the changes in gate voltages for recording and erasing the memories.

Referring to FIG. 7, the graph f1 illustrates the changes in the flat band voltage V_{FB} according to the changes in the gate voltage for recording the conventional SONOS memory. The graph f2 illustrates the changes in the flat band voltage V_{FB} according to the changes in the gate voltage for erasing the conventional SONOS memory. The graph g1 illustrates the changes in the flat band voltage V_{FB} according to the changes in the gate voltage for recording the SONSNOS memory. The graph g2 illustrates the changes in the flat band voltage V_{FB} according to the changes in the gate voltage for erasing the SONSNOS memory. At the gate voltages V_{G} under 12 V, the difference between the flat band voltage V_{FB} of the graph f1 and the flat band voltage V_{FB} of the graph f2 is smaller than the difference between the flat band voltage V_{FB} of the graph g1 and the flat band voltage V_{FB} of the graph g2. Accordingly, it is known that the performance of the SONSNOS memory according to the first embodiment of the present invention is better than that of the conventional SONOS memory.

The SONSNOS memory according to the present invention forms multi-nitride layers and multi-silicon layers and has the structure using silicon quantum dots or metal quantum dots to increase the trap sites for storing electrons. Accordingly, the SONSNOS memory can be programmed at a high rate while having an improved information recording capacity.

While this invention has been particularly shown and described with reference to preferred embodiments thereof, it will be understood by those skilled in the art that various changes in form and details may be made therein without departing from the invention as defined by the appended claims.

For example, nano-sized particles for forming nano-sized quantum dots can be prepared by various methods to be used in a single electron transistor.

It should be noted that the term SONSNOS is used in the present specification to refer to any SONOS type memory storing charge on trap sites with at least one intermediate layer and the term is not intended to be restricted to memories with only oxide, nitride, silicon, nitride oxide and silicon layers.

## Claims

1. A nonvolatile memory having a semiconductor substrate (101, 201) including source (103, 203) and drain (105, 205) electrodes that are separated by a predetermined distance and a channel for moving electrons between the source and drain electrodes, and a gate electrode (107, 207) formed on the semiconductor substrate to control the input of the electrons from the channel, the memory comprising:
first and second insulating layers (111, 131, 211, 213) stacked between the gate electrode and the channel of the substrate;
first and second dielectric layers (113, 133, 213, 233) between the first insulating layer and the second insulating layer,
**characterized in that** the first and second dielectric layers provide trap sites; and
further **characterized by** an intermediate semiconductor or metal layer (115, 135, 215, 235) interposed between the first and second dielectric layers for providing further trap sites.

2. A memory according to claim 1 wherein the intermediate layer (113, 213) is a group IV semiconductor layer.

3. A memory according to claim 1 or 2 wherein the intermediate layer (135, 235) comprises nanosized quantum dots that are formed of a group IV semiconductor material interposed between the first and second dielectric layers.

4. The memory of claim 2 or 3, wherein the group IV semiconductor is one of silicon (Si) and germanium (Ge).

5. A memory according to claim 1 wherein the intermediate layer (135, 235) includes nanosized quantum dots that are formed of a metal and are interposed between the first and second dielectric layers.

6. The memory of claim 5, wherein the metal is one of gold (Au) and aluminum (Al).

7. The memory of any preceding claim, wherein each of the first and second insulating layers (111, 131, 211, 213) is formed of one selected from the group formed of SiO₂, Al₂O₃, TaO₂, and TiO₂.

8. The memory of any preceding claim, wherein each of the first and second dielectric layers (113, 133, 213, 233) is formed of one of Si₃N₄ and PZT.

9. The memory of any one of claims 3 and 5, wherein the nanosized quantum dots are formed by one of a LPCVD method and a sputtering method.

10. A memory according to claim 1 comprising a plurality of dielectric layers (231, 233) formed on the first insulating layer (211, 231) and under the second insulating layer (213, 233), and a plurality of semiconductor or metal intermediate layers (215, 235) interposed between every dielectric layer.

11. A memory according to claim 10 wherein the intermediate layers (215, 235) are of group IV semiconductor.

12. A memory according to claim 10 or 11 wherein the intermediate layers (215, 235) comprise nanosized quantum dots that are formed of a group IV semiconductor material interposed between the intermediate layers.

13. The memory of claim 11 or 12, wherein the group IV semiconductor is one of silicon (Si) and germanium (Ge).

14. A memory according to claim 10 wherein the intermediate layers (215, 235) include nanosized quantum dots that are formed of a metal and are interposed between the first and second dielectric layers.

15. The memory of claim 14, wherein the metal is one of gold (Au) and aluminum (Al).

16. The memory of any one of claims 10 to 15 wherein each of the first and second insulating layers (211, 231) is formed of one selected from the group formed of SiO₂, Al₂O₃, TaO₂, and TiO₂.

17. The memory of any one of claims 10 to 16, wherein each of the first and second dielectric layers (213, 233) is formed of one of Si₃N₄ and PZT.

18. The memory of any one of claims 12 and 14, wherein the nanosized quantum dots are formed by one of a LPCVD method and a sputtering method.

## Patentansprüche

1. Nichtflüchtiger Speicher mit einem Halbleitersubstrat (101, 201) mit Source- (103, 203) und Drain- (105, 205) -Elektroden, die durch einen vorbestimmten Abstand voneinander getrennt sind, und einem Kanal zum Bewegen von Elektronen zwischen den Source- und Drain-Elektroden, und einer Gate-Elektrode (107, 207), die auf dem Halbleitersubstrat ausgebildet ist, um den Eingang der Elektronen von dem Kanal zu steuern, wobei der Speicher Folgendes umfasst:
erste und zweite Isolierschichten (111, 131, 211, 213), die zwischen der Gate-Elektrode und dem Kanal des Substrats gestapelt sind;
erste und zweite dielektrische Schichten (113, 133, 213, 233) zwischen der ersten Isolierschicht und der zweiten Isolierschicht,
**dadurch gekennzeichnet, dass** die erste und die zweite dielektrische Schicht Fangstellen bilden; und
ferner **gekennzeichnet durch** eine Halbleiter- oder Metallzwischenschicht (115, 135, 215, 235) zwischen der ersten und der zweiten dielektrischen Schicht zum Bereitstellen weiterer Fangstellen.

2. Speicher nach Anspruch 1, wobei die Zwischenschicht (113, 213) eine Schicht aus einem Halbleiter der Gruppe IV ist.

3. Speicher nach Anspruch 1 oder 2, wobei die Zwischenschicht (135, 235) Quantenpunkte in Nanogröße aufweist, die aus einem Halbleitermaterial der Gruppe IV gebildet sind, das sich zwischen der ersten und der zweiten dielektrischen Schicht befindet.

4. Speicher nach Anspruch 2 oder 3, wobei der Halbleiter der Gruppe IV Silicium (Si) oder Germanium (Ge) ist.

5. Speicher nach Anspruch 1, wobei die Zwischenschicht (135, 235) Quantenpunkte in Nanogröße aufweist, die aus einem Metall gebildet sind und sich zwischen der ersten und der zweiten dielektrischen Schicht befinden.

6. Speicher nach Anspruch 5, wobei das Metall Gold (Au) oder Aluminium (A1) ist.

7. Speicher nach einem der vorherigen Ansprüche, wobei jede der ersten und zweiten Isolierschichten (111, 131, 211, 213) aus einem Material gebildet ist, das aus der Gruppe bestehend aus SiO₂, Al₂O₃, TaO₂ und TiO₂ ausgewählt ist.

8. Speicher nach einem der vorherigen Ansprüche, wobei jede der ersten und zweiten dielektrischen Schichten (113, 133, 213, 213) aus Si₃N₄ oder PZT gebildet ist.

9. Speicher nach einem der Ansprüche 3 und 5, wobei die Quantenpunkte in Nanogröße mit einem LPVCD-Verfahren und einem Sputterverfahren gebildet werden.

10. Speicher nach Anspruch 1, der mehrere dielektrische Schichten (231, 233), die auf der ersten Isolierschicht (211, 231) und unter der zweiten Isolierschicht (213, 233) ausgebildet sind, und mehrere Halbleiter- oder Metallzwischenschichten (215, 235) umfasst, die sich jeweils zwischen den dielektrischen Schichten befinden.

11. Speicher nach Anspruch 10, wobei die Zwischenschichten (215, 235) aus einem Halbleiter der Gruppe IV bestehen.

12. Speicher nach Anspruch 10 oder 11, wobei die Zwischenschichten (215, 235) Quantenpunkte in Nanogröße umfassen, die aus einem Halbleitermaterial der Gruppe IV gebildet sind, das sich zwischen den Zwischenschichten befindet.

13. Speicher nach Anspruch 11 oder 12, wobei der Halbleiter der Gruppe IV Silicium (Si) oder Germanium (Ge) ist.

14. Speicher nach Anspruch 10, wobei die Zwischenschichten (215, 235) Quantenpunkte in Nanogröße umfassen, die aus einem Metall gebildet sind und sich zwischen der ersten und der zweiten dielektrischen Schicht befinden.

15. Speicher nach Anspruch 14, wobei das Metall Gold (Au) oder Aluminium (A1) ist.

16. Speicher nach einem der Ansprüche 10 bis 15, wobei jede der ersten und zweiten Isolierschichten (211, 231) aus einem Material gebildet ist, das aus der Gruppe bestehend aus SiO₂, Al₂O₃, TaO₂ und TiO₂ ausgewählt ist.

17. Speicher nach einem der Ansprüche 10 bis 16, wobei jede der ersten und zweiten dielektrischen Schichten (213, 233) aus Si₃N₄ oder PZT gebildet ist.

18. Speicher nach einem der Ansprüche 12 und 14, wobei die Quantenpunkte in Nanogröße mit einem LPVCD-Verfahren und einem Sputterverfahren gebildet werden.

## Revendications

1. Mémoire non volatile ayant un substrat semi-conducteur (101, 201) comprenant des électrodes de source (103, 03) et de drain (105, 205) qui sont séparées par une distance prédéterminée et un canal pour acheminer les électrons entre les électrodes de source et de drain, et une gâchette (107, 207) formée sur le substrat semi-conducteur pour commander l'entrée des électrons provenant du canal, la mémoire comprenant :
des première et deuxième couches isolantes (111, 131, 211, 213) empilées entre la gâchette et le canal du substrat ;
des première et deuxième couches diélectriques (113, 133, 213, 233) entre la première couche isolante et la deuxième couche isolante,
**caractérisée en ce que** les première et deuxième couches diélectriques fournissent des sites pièges ; et
**caractérisée en outre par** une couche semi-conductrice ou métallique intermédiaire (115, 135, 215, 235) interposée entre les première et deuxième couches diélectriques pour fournir d'autres sites pièges.

2. Mémoire selon la revendication 1, dans laquelle la couche intermédiaire (113, 213) est une couche semi-conductrice de groupe IV.

3. Mémoire selon la revendication 1 ou 2, dans laquelle la couche intermédiaire (135, 235) comprend des points quantiques d'une taille de l'ordre du nanomètre qui sont formés d'un matériau semi-conducteur de groupe IV interposé entre les première et deuxième couches diélectriques.

4. Mémoire selon la revendication 2 ou 3, dans laquelle le semi-conducteur de groupe IV est soit le silicium (Si) soit le germanium (Ge).

5. Mémoire selon la revendication 1, dans laquelle la couche intermédiaire (135, 235) comprend des points quantiques d'une taille de l'ordre du nanomètre qui sont formés d'un métal et sont interposés entre les première et deuxième couches diélectriques.

6. Mémoire selon la revendication 5, dans laquelle le métal est soit l'or (Au), soit l'aluminium (Al).

7. Mémoire selon l'une quelconque des revendications précédentes, dans laquelle chacune des première et deuxième couches isolantes (111, 131, 211, 213) est formée d'un membre du groupe formé de SiO₂, Al₂O₃, TaO₂ et TiO₂.

8. Mémoire selon l'une quelconque des revendications précédentes, dans laquelle chacune des première et deuxième couches diélectriques (113, 133, 213, 233) est formée soit de Si₃N₄ soit de PZT.

9. Mémoire selon l'une quelconque des revendications 3 et 5, dans laquelle les points quantiques d'une taille de l'ordre du nanomètre sont formés soit par la méthode de dépôt en phase vapeur de substances chimiques à basse pression, soit par la méthode de pulvérisation cathodique.

10. Mémoire selon la revendication 1, comprenant une pluralité de couches diélectriques (231, 233) formées sur la première couche isolante (211, 231) et sous la deuxième couche isolante (213, 233) et une pluralité de couches semi-conductrices ou métalliques (215, 235) interposées entre toutes les couches diélectriques.

11. Mémoire selon la revendication 10, dans laquelle les couches intermédiaires (215, 235) sont en matériau semi-conducteur de groupe IV.

12. Mémoire selon la revendication 10 ou 11, dans laquelle les couches intermédiaires (215, 235) comprennent des points quantiques de taille de l'ordre du nanomètre qui sont formés d'un matériau semi-conducteur de groupe IV interposé entre les couches intermédiaires.

13. Mémoire selon la revendication 11 ou 12, dans laquelle le semi-conducteur de groupe IV est soit le silicium (Si), soit le Germanium (Ge).

14. Mémoire selon la revendication 10, dans laquelle les couches intermédiaires (215, 235) comprennent des points quantiques de taille de l'ordre du nanomètre qui sont formés d'un métal et sont interposés entre les première et deuxième couches diélectriques.

15. Mémoire selon 1a revendication 14, dans laquelle le métal est soit l'or (Au) soit l'aluminium (Al).

16. Mémoire selon l'une quelconque des revendications 10 à 15, dans laquelle chacune des première et deuxième couches isolantes (211, 231) est formée d'un membre sélectionné dans le groupe formé de SiO₂, Al₂O₃, TaO₂ et TiO₂.

17. Mémoire selon l'une quelconque des revendications 10 à 16, dans laquelle chacune des première et deuxième couches diélectriques (213, 233) est formée soit de Si₃N₄, soit de PZT.

18. Mémoire selon l'une quelconque des revendications 12 et 14, dans laquelle les points quantiques de taille de l'ordre du nanomètre sont formés soit par la méthode de dépôt en phase vapeur de substances chimiques à basse pression, soit par la méthode de pulvérisation cathodique.
